(19) Europäisches Patentamt
European Patent Office
Office européen des brevets

(11) Publication number: **0 110 214 A1**

(12) # EUROPEAN PATENT APPLICATION

(21) Application number: 83111244.6

(22) Date of filing: 10.11.83

(51) Int. Cl.³: G 03 F 7/08, C 08 G 8/28

(30) Priority: 12.11.82 JP 197755/82

(43) Date of publication of application: 13.06.84 Bulletin 84/24

(84) Designated Contracting States: DE GB

(71) Applicant: FUJI PHOTO FILM CO., LTD., 210 Nakanuma Minami Ashigara-shi, Kanagawa 250-01 (JP)

(72) Inventor: Nagashima, Akira, c/o Fuji Photo Film Co.Ltd. No. 4000 Kawajiri, Yoshida-cho Haibara-gun Shizuoka (JP)
Inventor: Hasegawa, Akira, c/o Fuji Photo Film Co.Ltd. No. 4000 Kawajiri, Yoshida-cho Haibara-gun Shizuoka (JP)
Inventor: Aoai, Toshiaki, c/o Fuji Photo Film Co.Ltd. No. 210, Nakanuma, Minami Ashigara-shi Kanagawa (JP)
Inventor: Nagano, Teruo, c/o Fuji Photo Film Co.Ltd. No. 210, Nakanuma, Minami Ashigara-shi Kanagawa (JP)

(74) Representative: Barz, Peter, Dr. et al, Patentanwälte Dr. V. Schmied-Kowarzik Dipl.-Ing. G. Dannenberg Dr. P. Weinhold Dr. D. Gudel Dipl.-Ing. S. Schubert Dr. P. Barz Siegfriedstrasse 8, D-8000 München 40 (DE)

(54) **Photosensitive composition.**

(57) A photosensitive composition suitable for a photosensitive lithographic printing plate comprises a condensation product of a sulfonyl halide of o-quinonediazide and a high molecular compound shown by general formula I or II

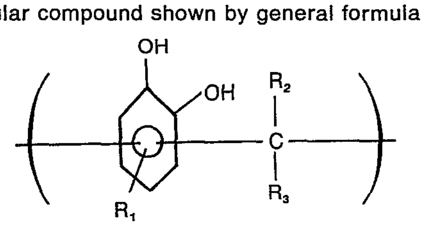

I

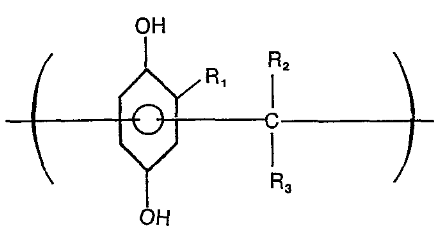

II

wherein $R_1$ is a hydrogen atom, an alkyl group having 1 to 8 carbon atoms and $R_2$ and $R_3$ each is a hydrogen atom or an alkyl group having 1 to 4 carbon atoms.

EP 0 110 214 A1

# PHOTOSENSITIVE COMPOSITION

This invention relates to a photosensitive composition suitable for producing photosensitive lithographic printing plates. More particularly, the invention relates to a photosensitive composition containing an o-quinonediazide compound as a photosensitive component.

It is known that when an o-quinonediazide compound is exposed to actinic radiation, the compound is decomposed to form a carboxylic acid of a 5-membered ring, whereby the compound is converted into an alkali-soluble material. Therefore, a photosensitive composition containing such an o-quinonediazide compound has been widely used for photosensitive lithographic printing plates, photoresists, etc., as a photosensitive composition obtaining posi-posi type images.

Such a diazo compound is generally used for photosensitive lithographic printing plates, etc., as the form of the sulfonic acid ester obtained by chemically condensing an o-quinonediazide compound having a halogenosulfonyl group such as sulfonyl chloride, etc., and a mono- or poly-hydroxyphenyl compound. Examples of the hydroxyphenyl compound to be condensed with the o-quinonediazide compound are 2,2'-dihydroxydiphenyl, 2,2',4,4'-tetrahydroxydiphenyl, 2,3-dihydroxynaphthalene, p-t-butylphenol, etc.

In these diazo compounds relatively high molecular weight o-quinonediazide compounds such as the o-naphthoquinonediazidosulfonic acid esters of a phenol-formaldehyde resin or an o-cresol-formaldehyde resin described in U.S. Patent No. 3,046,120 are excellent with respect to matters such as good film-forming property, etc., and have been widely used.

Also, Japanese Patent Application (OPI) Nos. 1045/'81 (corresponding to U.S. Patent 4,306,011) and 1044/'81 (corresponding to U.S. Patent 4,306,010), Japanese Patent Publication Nos. 28,403/'68 (corresponding to U.S. Patent 3,635,709) and 24,361/'74, etc., disclose o-quinonediazidosulfonic acid esters of the condensation products of polyhydric phenols and aldehydes or ketones. Such o-quinonediazidosulfonic acid esters of the condensation products of polyhydric phenols and aldehydes or ketones have an advantage that they can be developed by a relatively weak alkaline developer as compared to the o-quinonediazidosulfonic acid esters of a phenol-formaldehyde resin or a cresol-formaldehyde resin but have a disadvantage that when the photosensitive composition composed of such an ester is formed on an anodically

oxidized aluminum support, a small amount of the photosensitive composition is liable remain on the non-image areas as patches after development. Such patches provide an undesirable appearance and when the developed photosensitive lithographic printing plate having such patches is used as a lithographic printing plate, stains form on the prints.

An object of this invention is, therefore, to provide a photosensitive composition which can be developed by a weak alkaline developer and which is not likely to remain partially on the non-image areas after developing a photosensitive lithographic printing plate precursor having the photosensitive composition as the photosensitive layer.

Another object of this invention is to provide a photosensitive composition having a good film-forming property.

Still another object of this invention is to provide a photosensitive composition which can give clean prints without having stains when the photosensitive composition is used for a lithographic printing plate.

As the result of various investigations for attaining the foregoing objects of this invention, the inventors have discovered that these objects can be

attained by a photosensitive composition containing a condensation product of the sulfonyl halide (e.g., chloride, bromide etc., more preferably chloride) of o-quinonediazide and a high molecular compound having the structure shown by following general formula I or II;

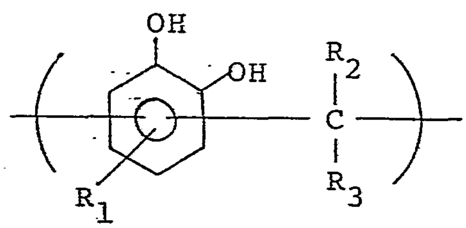

I

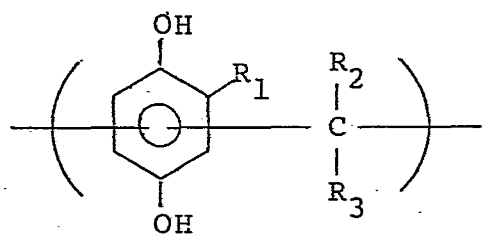

II

wherein $R_1$ represents a hydrogen atom, an alkyl group having 1 to 8 carbon atoms, or a cycloalkyl group having 3 to 8 carbon atoms and $R_2$ and $R_3$ each represents a hydrogen atom or an alkyl group having 1 to 4 carbon atoms.

It is astonishing that when the photosensitive composition of this invention is used for a photosensitive lithographic printing plate, the photosensitive composition scarecely remains on the non-image areas after developing the lithographic printing plate precursor. Such results

are quite different from using photosensitive compositions described in Japanese Patent Application (OPI) Nos. 1045/'81, 1044/'81, etc. The reason for the difference has not yet been clarified but it is believed that the high molecular compound of this invention shown in general formula I or II contains a catechol derivative or a hydroquinone derivative respectively, while those disclosed in Japanese Patent Application (OPI) Nos. 1045/'81, 1044/'81, etc., contain resorcin derivatives.

Japanese Patent Publication No. 24,361/'74 discloses a photosensitive composition containing the condensation product of the sulfonyl halide of o-quinonediazide and a resin prepared from a dihydric phenol having a hydrocarbon group and a monohydric phenol. However, since the condensation product has a long chain (10 to 20 carbon atoms) hydrocarbon group and contains a monohydric phenol in the molecule, the photosensitive composition is reluctant to dissolve in a weak alkaline developer and is fundamentally different from the photosensitive composition of this invention.

In general formulae I and II, $R_1$ is a hydrogen atom, an alkyl group having 1 to 8 carbon atoms, or a cycloalkyl group having 3 to 8 carbon atoms as described above but is preferably an ethyl group, a n-propyl group, a n-butyl group, a t-butyl group, or a n-hexyl group.

Also, $R_2$ and $R_3$ each is a hydrogen atom or an alkyl group having 1 to 4 carbon atoms and in a preferred embodiment, $R_2$ is a hydrogen atom and $R_3$ is a methyl group or an ethyl group. Furthermore, the molecular weight of the high molecular compounds shown by general formulae I and II effectively used in this invention is about 500 to 10,000, preferably about 800 to 4,000.

The high molecular compounds shown by general formulae I and II used in this invention are prepared as follows.

That is, each of the desired high molecular compounds can be obtained by condensing a polyhydric phenol as a catechol (when preparing the compound shown by general formula I) such as catechol, 4-ethylcatechol, 4-t-butylcatechol, etc., or a hydroquinone (when preparing the compound shown by general formula II) such as hydroquinone, 2-n-propylhydroquinone, etc., with an aldehyde or a ketone such as formaldehyde, acetoaldehyde, acetone, methyl ethyl ketone, etc., which are solely or in the state of the solution thereof in a solvént such as an alcohol, dioxane, etc., in an amount of 0.85 to 1.0 mol per mol of the polyhydric phenol using an acid such as hydrochloric acid, oxalic acid, etc., or an alkali such as sodium hydroxide, aqueous ammonia, etc., as a catalyst. In this case any desired combination of a polyhydric

phenol and an aldehyde or a ketone may be used and further, two or more kinds of the polyhydric phenols or the aldehydes or ketones may be used.

Examples of the sulfonyl chloride compound of o-quinonediazide used in this invention are 1,2-benzoquinone-2-diazido-4-sulfonyl chloride, 1,2-naphthoquinone-2-diazido-4-sulfonyl chloride, 1,2-naphthoquinone-2-diazido-5-sulfonyl chloride, etc. of the above sulfonyl chloride compounds, more preferable examples are 1,2-naphthoquinone-2-diazido-4-sulfonyl chloride and 1,2-naphthoquinone-2-diazido-5-sulfonyl chloride and most preferable example is 1,2-naphthoquinone-2-diazido-5-sulfonyl chloride.

The condensation product of the sulfonyl chloride of o-quinonediazide and the high molecular compound shown by general formula I or II is prepared as follows. That is, the sulfonyl chloride of o-quinonediazide and the high molecular compound are dissolved in a solvent such as dioxane, methyl ethyl ketone, tetrahydrofuran, dimethylformamide, etc., and an alkali such as sodium carbonate, etc., is added to the solution with stirring at room temperature or at a temperature of 40 to 50°C to easily cause the esterification. The reaction ratio of the sulfonyl chloride to the high molecular compound shown by general formula I or II employed in the aforesaid

esterification is 1:0.1 to 1:3, preferably 1:0.3 to 1:1.

Typical synthesis examples of the condensation products of the sulfonyl chloride of o-quinonediazide and the high molecular compounds shown by general formula I or II are shown hereinafter.

SYNTHESIS EXAMPLE 1

In 500 ml of 1,4-dioxane was dissolved 332 g of 4-t-butylcatechol and 162 g of 37% formalin was added to the solution with stirring. Furthermore, 1 ml of 5N hydrochloric acid was added to the solution as a catalyst and the mixture was mildly refluxed in order to avoid the occurrence of bumping. After 5 hours, the reaction mixture thus formed was poured in 3 liters of cold water and a light yellow resin thus deposited was collected by filtration and dried to provide 302 g of the resin. The molecular weight of the resin measured by a light scattering method was about 2,200.

In 60 ml of a mixture of methyl ethyl ketone and dimethylformamide (5:1) was dissolved 17.9 g of the resin and the solution was added to a solution of 18.9 g of 1,2-naphthoquinone-2-diazido-5-sulfonyl chloride in 90 ml of a mixture of methyl ethyl ketone and dimethylformamide (5:1). After stirring the mixture for one hour at room temperature, 7.1 g of triethylamine was added dropwise to the mixture and after further adding thereto 5 ml of water,

the pH of the reaction system was adjusted to 6.0 to 6.5 with triethylamine. The reaction was added to 1.2 liters of cold water with stirring and a yellow powder thus deposited was collected by filtration. The powder was purified by reprecipitation and dried. The amount of the product thus obtained was 32 g. The esterification ratio of the resin per unit skeleton calculated from the UV spectra was 46%.

SYNTHESIS EXAMPLE 2

In 500 ml of 1,4-dioxane was dissolved 332 g of 4-t-butylcatechol and then 88 g of acetoaldehyde was added to the solution with stirring. Furthermore, 1 ml of 5N hydrochloric acid was added to the solution as a catalyst and the mixture was mildly refluxed in order to avoid the occurrence of bumping. After 5 hours, the reaction mixture was poured into 3 liters of cold water and a light yellow resin thus deposited was collected by filtration and dried to provide 298 g of the resin. The molecular weight of the resin measured by a light scattering method was about 1,800.

In 60 ml of a mixture of methyl ethyl ketone and dimethylformamide (5:1) was dissolved 19.2 g of the resin and the solution was added to a solution of 19.2 g of 1,2-naphthoquinone-2-diazido-5-sulfonyl chloride in 90 ml of a mixture of methyl ethyl ketone and dimethylformamide

(5:1). After stirring the mixture for one hour at room temperature, 7.2 g of triethylamine was added dropwise to the mixture and after further adding thereto 5 ml of water, the pH of the reaction system was adjusted to 6.0 to 6.5 with triethylamine. The reaction mixture was poured into 1.2 liters of cold water with stirring and a yellow powder thus deposited was collected by filtration. The powder was purified by reprecipitation and then dried to provide 31 g of the product powder. The esterification ratio of the resin per unit skeleton calculated by the UV spectra was 50%.

SYNTHESIS EXAMPLE 3

In 500 ml of 1,4-dioxane was dissolved 332 g of 2-t-butylhydroquinone and 162 g of 37% formalin was added to the solution with stirring. Furthermore, 1 ml of 5N hydrochloric acid was added to the solution as a catalyst and the mixture was mildly refluxed in order to avoid the occurrence of bumping. After 5 hours, the reaction mixture was poured into 3 liters of cold water and a light yellow resin thus deposited was collected by filtration and dried to provide 276 g of the resin. The molecular weight of the resin measured by a light scattering method was about 1,600.

In 60 ml of a mixture of methyl ethyl ketone and dimethylformamide (5:1) was dissolved 17.9 g of the resin

and the solution was added to a solution of 18.9 g of 1,2-naphthoquinone-2-diazido-5-sulfonyl chloride in 90 ml of a mixture of methyl ethyl ketone and dimethylformamide (5:1). After stirring the mixture for one hour at room temperature, 7.1 g of triethylamine was added dropwise to the mixture and after further adding thereto 5 ml of water, the pH of the reaction system was adjusted to within the range of 6.0 to 6.5 with triethylamine. The reaction mixture was added to 1.2 liters of cold water with stirring and a yellow powder thus deposited was collected by filtration. The powder was purified by reprecipitation and dried to provide 22 g of the product powder. The esterification ratio of the resin per unit skeleton calculated by the UV spectra was 56%.

## SYNTHESIS EXAMPLE 4

In 500 ml of 1,4-dioxane was dissolved 220 g of hydroquinone and 130 g of 37% formalin was added to the solution with stirring. Furthermore, 1 ml of 5N hydrochloric acid was added to the solution as a catalyst and the mixture was mildly refluxed in order to avoid the occurrence of bumping. After 2 hours, the reaction mixture was poured into 3 liters of cold water and a light yellow resin thus deposited was collected by filtration and dried to provide 142 g of the resin. The molecular weight of the resin measured by a light scattering method

was about 1,300.

In 60 ml of a mixture of methyl ethyl ketone and dimethylformamide (5:1) was dissolved 12.3 g of the resin and the solution was added to a solution of 12.4 g of 1,2-naphthoquinone-2-diazido-5-sulfonyl chloride in 90 ml of a mixture of methyl ethyl ketone and dimethylformamide (5:1). After stirring the mixture for one hour at room temperature, 4.7 g of triethylamine was added dropwise to the solution and after further adding thereto 5 ml of water, the pH of the reaction system was adjusted to 6.0 to 6.5 with triethylamine. The reaction mixture was poured into 1.2 liters of cold water with stirring and a yellow powder thus deposited was collected by filtration. After purifying the powder by reprecipitation, the powder was dried to provide 13.2 g of the product powder. The esterification ratio of the resin per unit skeleton calculated by the UV spectra was 50%.

It is preferred to use the o-quinonediazide compound in this invention only in the photosensitive composition of this invention as a photosensitive component but the o-quinonediazide compound may be used together with a known o-naphthoquinonediazide compound.

As the o-naphthoquinonediazide compound, the ester of 1,2-naphthoquinone-2-diazido-5-sulfonyl chloride and a pyrogallol-acetone resin is most preferred. Examples of other suitable known o-naphthoquinonediazide compounds are the esters of 1,2-naphthoquinone-2-diazido-5-sulfonyl chloride and phenol-formaldehyde resins described in U.S. Patent Nos. 3,046,120 and 3,188,210. Other known o-naphthoquinonediazide compounds used in this invention are described in Japanese Patent Application (OPI) Nos. 5303/'72 (corresponding to U.S. Patent 3,644,118); 63,802/'73; 63,803/'73; 96,575/'73 (corresponding to Canadian Patent 1,008,593); 38,701/'74; and 13,354/'73 (corresponding to U.S. Patent 3,711,285); Japanese Patent Publication Nos. 11,222/'66; 9610/'70; and 17,481/'74; U.S. Patent Nos. 2,797,213; 3,454,400; 3,544,323; 3,573,917; 3,674,495 and 3,785,825; British Patent Nos. 1,227,602; 1,251,345; 1,267,005; 1,329,888; and 1,330,932; and German Patent No. 854,890.

The total amount of the o-quinonediazide compound of the present invention and the prior art contained in the photosensitive composition is 5 to 80% by weight, preferably 20 to 40% by weight. The amount of the o-quinonediazide compound of the present invention contained in the total o-quinonediazide compound is 20 to 100% by weight.

The photosensitive composition of this invention may further contain a known alkali-soluble high molecular compound such as a phenol-formaldehyde resin, a cresol-formaldehyde resin, a phenol-modified xylene resin, polyhydroxystyrene, halogenated polyhydroxystyrene, etc. The proportion of such an alkali-soluble high molecular compound is less than 70% by weight of the total amount of the photosensitive composition.

The photosensitive compositions of this invention may further contain a cyclic acid anhydride for increasing the sensitivity, a printing out agent for obtaining a visible image directly after exposure, a dye as an image coloring agent, and other fillers. Examples of the cyclic acid anhydride are phthalic anhydride, tetrahydrophthalic anhydride, hexahydrophthalic anhydride, 3,6-endoxy-$\Delta^4$-tetrahydrophthalic anhydride, tetrachlorophthalic anhydride, maleic anhydride, chloromaleic anhydride, α-phenylmaleic anhydride, succinic anhydride, pyromellitic anhydride, etc., as described in U.S. Patent 4,115,128. By incorporating the cyclic acid anhydride in the photosensitive composition in an amount of 1 to 15% by weight of the total amount of the composition, the sensitivity thereof can be increased at most about 3 times the original sensitivity. As the printing out agent for obtaining a visible image directly after light exposure, there is a combination of a photosensitive compound capable of releasing an acid by light exposure and an organic dye capable of forming a salt. Practical examples are the

combination of o-naphthoquinonediazido-4-sulfonic acid halogenide and a salt-forming organic dye described in Japanese Patent Application (OPI) Nos. 36,209/'75 (corresponding to U.S. Patent 3,969,118) and 8128/'78 and a combination of a trihalomethyl compound and a salt-forming organic dye described in Japanese Patent Application (OPI) Nos. 36,223/'78 (corresponding to U.S. Patent 4,160,671) and 74,728/'79 (corresponding to U.S. Patent 4,212,970). As the coloring agent, other dyes than the foregoing salt-forming organic dyes can be also used. As the preferred dyes including the salt-forming organic dyes, there are illustrated oil-soluble dyes and basic dyes. Practical examples of these dyes are Oil Yellow #101, Oil Yellow #130, Oil Pink #312, Oil Green BG, Oil Blue BOS, Oil Blue #603, Oil Black BY, Oil Black BS, Oil Black T-505 (the above dyes are trade names, made by Orient Kagaku Kogyo K.K.), Crystal Violet (CI 42555), Methyl Violet (CI 42535), Rhodamine B (CI 45170B), Malachite Green (CI 42000), Methylene Blue (CI 52015), etc.

The photosensitive composition of this invention is coated on a support as a solution in a solvent dissolving the foregoing components. Solvents used for this purpose include ethylene dichloride, cyclohexanone, methyl ethyl ketone, ethylene glycol monomethyl ether, ethylene glycol monoethyl ether, 2-methoxyethyl acetate, toluene and ethyl acetate. These solvents may be used solely or as a mixture of them. Also, the concentration (as solid

content) of the foregoing components in the solution of the photosensitive composition of this invention is 2 to 50% by weight. The coating amount (coverage) of the coating liquid depends upon the use of the photosensitive composition but generally is preferably 0.5 to 3.0 $g/m^2$ as solid content in the case of using the composition for, for example, a photosensitive lithographic printing plate. With the decrease of the coating amount of the photosensitive composition, the light sensitivity of the photosensitive lithographic printing plate is increased but the mechanical property of the photosensitive layer is reduced.

When producing a photosensitive lithographic printing plate using the photosensitive composition of this invention, the photosensitive composition is coated on a support such as an aluminum plate subjected to a hydrophilic treatment, e.g., an aluminum plate subjected to a silicate treatment, an anodically oxidized aluminum plate, a grained aluminum plate, a silicate-electrodeposited aluminum plate, a zinc plate, a stainless steel plate, a chromed steel plate, a plastic film or paper subjected to a hydrophilic treatment, etc.

As a suitable developer for the photosensitive composition of this invention, there is an aqueous solution of an inorganic alkalifying agent such as sodium silicate,

potassium silicate, sodium hydroxide, potassium hydroxide, lithium hydroxide, sodium tertiary phosphate, sodium secondary phosphate, ammonium tertiary phosphate, ammonium secondary phosphate, sodium metasilicate, sodium hydrogencarbonate, ammonia (aqueous ammonia), etc. The concentration of the alkalifying agent is generally 0.1 to 10% by weight, preferably 0.5 to 5% by weight.

The alkaline aqueous solution may contain, if necessary, a surface active agent and an organic solvent such as an alcohol.

The invention will now be explained in more detail by the following examples. However, the scope of the invention is not limited to these examples. In addition, all percentages in the following examples are, unless otherwise indicated, by weight.

## EXAMPLE 1

A 2S aluminum plate of 0.24 mm in thickness was immersed in an aqueous solution of 10% sodium tertiary phosphate maintained at 80°C for 3 minutes to perform degreasing, after graining with a nylon brush, is etched in sodium aluminate for about 10 seconds, and is subjected to a desmut treatment with an aqueous solution of 3% sodium hydrogensulfate. The aluminum plate was anodically oxidized in 20% sulfuric acid at a current density of 2 amperes/$dm^2$ for 2 minutes to provide an aluminum plate (1).

The aluminum plate (1) was coated with a photosensitive liquid (A) having the following composition and dried for 2 minutes at 100°C to provide a photosensitive lithographic printing plate (A) of this invention.

Photosensitive liquid (A):

| | |
|---|---|
| The compound obtained in Synthesis Example 1 | 0.9 g |
| Phthalic anhydride | 0.2 g |
| Phenol-formaldehyde resin | 1.9 g |
| 2-(p-Butoxyphenyl)-4,6-bis(trichloromethyl)-s-triazine | 0.02 g |
| 1,2-Naphthoquinone-2-diazido-4-sulfonyl chloride | 0.02 g |
| Oil soluble dye (CI 42595) | 0.03 g |
| Ethylene dichloride | 15 g |
| Methylcellosolve | 8 g |

The coverage of the coating liquid after drying was 2.5 $g/m^2$.

COMPARATIVE EXAMPLE 1

An aluminum plate as above described was coated with a photosensitive liquid (B) using a condensation product of a phenol-formaldehyde resin and 1,2-naphthoquinone-2-diazido-5-sulfonyl chloride in place of the compound obtained in Synthesis Example 1 in the photosensitive liquid (A) by the same manner as when coating the photosensitive liquid (A) to provide a photosensitive

lithographic printing plate (B). The coverage of the photosensitive liquid after drying was 2.5 $g/m^2$.

COMPARATIVE EXAMPLE 2

An aluminum plate as above described was coated with a photosensitive liquid (C) using a condensation product of 1,2-naphthoquinone-2-diazido-5-sulfonyl chloride and a reaction product of 2-methylresorcin and acetaldehyde (the compound described in Example 1 of Japanese Patent Application (OPI) No. 1045/'81) in place of the compound obtained in Synthesis Example 1 in the photosensitive liquid (A) by the same manner as when coating the photosensitive liquid (A) to provide a photosensitive lithographic printing plate (C). The coverage of the photosensitive liquid after drying was 2.5 $g/m^2$.

On the photosensitive layer of each of the photosensitive lithographic printing plates (A), (B), and (C) was closely placed a positive transparency having a line image and a dot image and the photosensitive layer was exposed to a carbon arc lamp of 30 amperes at a distance of 70 cm.

Each of the exposed photosensitive lithographic printing plates (A), (B), and (C) was rubbed for development by a sponge impregnated with an aqueous solution of 1% sodium metasilicate (9-hydrate). In this case the photosensitive lithographic printing plate (A) of this

invention was quickly developed to provide a clean lithographic printing plate leaving almost no photosensitive composition at the non-image portions. On the other hand, the comparison photosensitive lithographic printing plate (B) could not be developed since the photosensitive composition at the exposed non-image portions was not dissolved in the developer. Also, the comparison photosensitive lithographic printing plate (C) could be quickly developed but a part of the photosensitive composition remained on the non-image portions as patches and the patches once formed could not be removed even by applying the development again.

Each of the developed lithographic printing plates (A) and (C) was printed on an offset printing machine. Clean impressions having no stains were obtained in the case of the lithographic printing plate (A) by the invention but the impressions obtained using the comparison lithographic printing plate (C) were partially stained.

## EXAMPLE 2

An aluminum plate treated as the aluminum plate (1) in Example 1 was coated with a photosensitive liquid (D) having the following composition by the same manner as in Example 1 to provide a photosensitive lithographic printing plate (D) of this invention.

Photosensitive liquid (D):

| | |
|---|---|
| The compound obtained in Synthesis Example 3 | 0.9 g |
| Phthalic anhydride | 0.1 g |
| Phenol-formaldehyde resin | 1.9 g |
| 1,2-Naphthoquinone-2-diazido-4-sulfonyl chloride | 0.02 g |
| Oil-soluble dye (CI 42595) | 0.03 g |
| Ethylene dichloride | 15 g |
| Methylenecellulose | 8 g |

COMPARATIVE EXAMPLE 3

An aluminum plate as above described was coated with a photosensitive liquid (E) using a condensation product of 1,2-naphthoquinone-2-diazido-5-sulfonyl chloride and a reaction product of resorcin and benzaldehyde (the compound described in Example 1 of Japanese Patent Application (OPI) No. 1044/'81) in place of the compound obtained in Synthesis Example 3 in the photosensitive liquid (D) by the same manner as the case of coating the photosensitive liquid (A) to provide a photosensitive lithographic printing plate (E).

COMPARATIVE EXAMPLE 4

An aluminum plate as above described was coated with a photosensitive liquid (F) using a condensation product of a m-cresol-formaldehyde resin and 1,2-naphthoquinone-2-diazido-5-sulfonyl chloride in place of

the compound obtained in Synthesis Example 3 in the photosensitive liquid (D) in the same manner as when coating the photosensitive liquid (A) to provide a photosensitive lithographic printing plate (F).

The coating amount (coverage) of the photosensitive liquid after drying was 2.0 $g/m^2$ in the photosensitive lithographic printing plates (D), (E), and (F).

On the photosensitive layer of each of the photosensitive lithographic printing plates (D), (E), and (F) was closely placed a positive transparency having a line image and a dot image and the photosensitive layer was exposed to a carbon arc lamp of 30 amperes at a distance of 70 cm.

Each of the exposed photosensitive lithographic printing plates (D), (E), and (F) was rubbed for development by a sponge impregnated with an aqueous solution of 1% sodium silicate (9-hydrate). In this case the photosensitive lithographic printing plate (D) of this invention was quickly developed to provide a clean printing plate leaving almost no photosensitive composition at the non-image portions. The comparison photosensitive lithographic printing plate (E) could be quickly developed but a part of the photosensitive composition remained on the non-image portions as patches and the patches could not be removed by applying the development again. Also, the comparison

photosensitive lithographic printing plate (F) could not be developed since the photosensitive composition at the exposed non-image portions was not dissolved in the developer and could scarecely be developed by increasing the concentration of sodium metasilicate in the developer to 3%.

Each of the developed lithographic printing plates (D) and (E) was printed on an offset printing machine. Clean impressions having no stains were obtained when using the lithographic printing plate (D) of this invention but the impressions obtained using the comparison lithographic printing plate (E) were partially stained.

CLAIMS

1. A photosensitive composition comprising a condensation product of a sulfonyl halide of o-quinonediazide and a high molecular compound having the structure shown by general formula I or II;

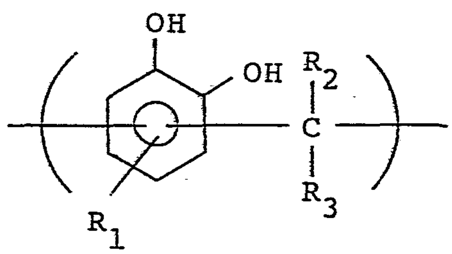

I

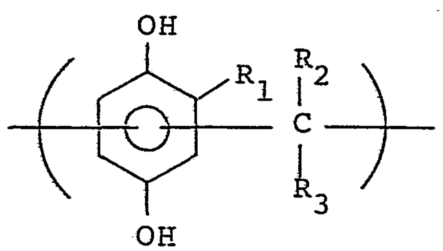

II

wherein $R_1$ represents a hydrogen atom, an alkyl group having 1 to 8 carbon atoms, or a cycloalkyl group having 3 to 8 carbon atoms and $R_2$ and $R_3$ each represents a hydrogen atom or an alkyl group having 1 to 4 carbon atoms.

2. The photosensitive composition as claimed in Claim 1 wherein the general formulae I and II, $R_1$ is an ethyl group, a n-propyl group, a n-butyl group, a t-butyl group, or a n-pentyl group; $R_2$ is a hydrogen atom; and $R_3$ is a methyl group or an ethyl group.

3. The photosensitive composition as claimed in

Claim 1 wherein the high molecular compound shown by general formula I or II has a molecular weight of about 500 to 10,000.

4. A photosensitive composition as claimed in Claim 3, wherein the compound shown by general formula I or II has a molecular weight in the range of 800 to 4,000.

5. A photosensitive composition as claimed in Claim 1, wherein the sulfonyl halide of o-quinonediazide is selected from the group consisting of 1,2-benzoquinone-2-diazido-4-sulfonyl chloride, 1,2-naphthoquinone-2-diazido-4-sulfonyl chloride and 1,2-naphthoquinone-2-diazido-5-sulfonyl chloride.

6. A photosensitive composition as claimed in Claim 1, wherein the reaction ratio of the sulfonyl halide to the high molecular compound is in the range of 1:0.1 to 1:3.

7. A photosensitive composition as claimed in Claim 6, wherein the reaction ratio of the sulfonyl halide to the high molecular compound is in the range of 1:0.3 to 1:1.

8. A photosensitive composition as claimed in Claim 1, wherein the sulfonyl halide of o-quinonediazide present in the composition totals in an mount in the range of 5 to 80% by weight.

9. A photosensitive composition as claimed in Claim

8, wherein the o-quinonediazido compound is present in an amount in the range of 20 to 40% by weight.

10. A photosensitive lithographic printing plate precursor which comprises an aluminium support having coated thereon the photosensitive composition of any of claims 1 to 9.

European Patent Office

# EUROPEAN SEARCH REPORT

0110214

Application number

EP 83 11 1244

## DOCUMENTS CONSIDERED TO BE RELEVANT

| Category | Citation of document with indication, where appropriate, of relevant passages | Relevant to claim | CLASSIFICATION OF THE APPLICATION (Int. Cl. 3) |
|---|---|---|---|
| X,Y | FR-A-2 312 799 (EASTMAN KODAK) * page 6, lines 2-9; claims * --- | 1-10 | G 03 F 7/08<br>C 08 G 8/28 |
| X | JP-B-49 024 361 (TOKYO-OUKA) * the entire document * & Derwent Japanese Patents Report, volume 74, no. 26, August 2, 1974, London, (GB) "Photosensitive phenol resin contg. an O-diazoquinone", page G2 --- | 1-10 | |
| X | GB-A-1 113 759 (FUJI) * claims * --- | 1-10 | |
| X | DE-A-2 545 957 (BASF) * page 4, lines 25-31 * --- | 1-10 | TECHNICAL FIELDS SEARCHED (Int. Cl. 3) |
| Y | DE-A-2 146 167 (KONISHIROKU PHOTO) * claims * --- | 1-10 | G 03 F 7/08<br>C 08 G 8/28 |
| Y | DE-A-2 512 933 (FUJI PHOTO) * claims * --- | 1-10 | |
| Y | EP-A-0 021 716 (KONISHIROKU PHOTO) * claims * --- -/- | 1-10 | |

The present search report has been drawn up for all claims

| Place of search | Date of completion of the search | Examiner |
|---|---|---|
| THE HAGUE | 16-02-1984 | RASSCHAERT A. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503. 03.82

European Patent Office

# EUROPEAN SEARCH REPORT

0110214

Application number

EP 83 11 1244

Page 2

## DOCUMENTS CONSIDERED TO BE RELEVANT

| Category | Citation of document with indication, where appropriate, of relevant passages | Relevant to claim | CLASSIFICATION OF THE APPLICATION (Int. Cl. 3) |
|---|---|---|---|
| Y | EP-A-0 021 718 (KONISHIROKU PHOTO) * claims * | 1-10 | |
| | --- | | |
| Y | EP-A-0 054 258 (KONISHIROKU PHOTO) * claims * | 1-10 | |
| | ----- | | |
| | | | TECHNICAL FIELDS SEARCHED (Int. Cl. 3) |

The present search report has been drawn up for all claims

| Place of search | Date of completion of the search | Examiner |
|---|---|---|
| THE HAGUE | 16-02-1984 | RASSCHAERT A. |

CATEGORY OF CITED DOCUMENTS

- X : particularly relevant if taken alone
- Y : particularly relevant if combined with another document of the same category
- A : technological background
- O : non-written disclosure
- P : intermediate document
- T : theory or principle underlying the invention
- E : earlier patent document, but published on, or after the filing date
- D : document cited in the application
- L : document cited for other reasons
- & : member of the same patent family, corresponding document

EPO Form 1503. 03.82